# EUROPÄISCHE PATENTSCHRIFT

(11) **EP 2 279 531 B1**
(45) Veröffentlichungstag und Bekanntmachung des Hinweises auf die Patenterteilung: **03.01.2018**
(21) Anmeldenummer: 09753586.8
(22) Anmeldetag: 09.04.2009
(51) Int. Cl.: H01L 31/024, H01L 31/052, H01L 31/02

(54) **Solarzellenmodul**
Solar cell module
Module de cellules solaires

(30) Priorität: 15.04.2008 EP 08007395
(43) Veröffentlichungstag der Anmeldung: 02.02.2011
(73) Patentinhaber: Fraunhofer-Gesellschaft zur Förderung der angewandten Forschung e.V., 80686 München (DE)
(72) Erfinder: JAUS, Joachim, 79098 Freiburg (DE); BETT, Andreas, 79114 Freiburg (DE)
(86) Internationale Anmeldenummer: PCT/EP2009/002653
(87) Internationale Veröffentlichungsnummer: WO 2009/143931

(56) Entgegenhaltungen:
- WO-A-91/18420
- FR-A- 2 500 685
- US-A- 6 130 465

## Beschreibung

Die Erfindung betrifft ein Solarzellenmodul enthaltend mindestens zwei miteinander verschaltete, Solarzellen aufweisende Baugruppen (SCA) sowie eine Modulbodenplatte enthaltend eine elektrisch leitfähige Trägerstruktur und eine zumindest auf der der Trägerstruktur zugewandten Seite elektrisch isolierte Rückseitenplatte. Die die Solarzelle enthaltende Baugruppe ist dabei von der Dimensionierung besonders klein, was zu einem geringen Materialverbrauch an Kühlkörpermaterial, z.B. Kupfer und Aluminium, führt und somit eine besonders kostengünstige Herstellung ermöglicht.

Zur direkten Erzeugung von elektrischer Energie aus dem Sonnenlicht finden heute Photovoltaik-Module bereits große Verbreitung. Eine in naher Zukunft besonders viel versprechende Technologie auf diesem Gebiet ist die Konzentrator-Photovoltaik, bei der mittels eines optischen Systems die Sonnenenergie aufkonzentriert und anschließend von besonders leistungsfähigen Solarzellen in elektrische Energie umgewandelt wird (siehe z.B. A.W. Bett, F. Dimroth, S.W. Glunz et al., "FLATCON™ and FLASHCON™ Concepts for High Concentration PV", Proc. Of 19th European Photovoltaic Solar Energy Conference, 2004, S. 2488-2491).

Durch die Konzentration des Sonnenlichts wird ein Brennfleck mit relativ hoher Strahlungsdichte erzeugt. Diese Strahlungsenergie wird zu einem bestimmten Teil in der Solarzelle in elektrische Energie umgewandelt. Dieser Anteil wird durch den Wirkungsgrad der Solarzelle bestimmt, der in den letzten Jahren rasant gestiegen ist und heute 40 % überschritten hat (R.R. King, D.C. Law, K.M. Edmondson et al., "40% efficient metamorphic GaInP/GaInAs/Ge multijunction solar cells", Applied Physics Letters, 90, 2007, S. 1835161-1835163) .

Der Teil der Strahlungsenergie, der nicht in elektrische Energie umgewandelt wird, fällt als thermische Verlustenergie an. Aufgrund der hohen Strahlungsdichte ergeben sich hierdurch besonders hohe Anforderungen an das thermische Design eines Konzentrator-Moduls. Da der Wirkungsgrad und die Lebensdauer einer Solarzelle mit höherer Temperatur sinken, ist es das Ziel jeder Entwicklung in diesem Bereich, durch geeignete Maßnahmen die Temperatur der Solarzelle so gering wie möglich zu halten.

Die hohe Flussdichte der Wärmeenergie in der Konzentrator-Photovoltaik erfordert die Ankopplung der Solarzellen an eine aktiv oder passiv gekühlte Wärmesenke. Um die Kosten für ein solches Konzentrator-Modul besonders niedrig zu halten, stehen hier insbesondere eine geeignete Kombination von Materialien sowie ein für die Massenfertigung geeignetes Design im Vordergrund. Zusätzlich zur Ableitung der Wärme müssen in einem Konzentrator-Solarmodul die einzelnen Solarzellen elektrisch miteinander verschaltet werden. Um die mit der Stromstärke quadratisch ansteigenden Widerstandsverluste möglichst klein zu halten, wird meistens eine Serienverschaltung aller Solarzellen oder auch von mehreren parallel verschalteten Solarzellengruppen durchgeführt.

Die Kühlkörper werden bisher meist als einzelnes Bauelement ausgelegt und entsprechend dimensioniert, sog. Solarzellenbaugruppe SCA, engl. Solar Cell Assembly. Die einzelnen Solarzellen werden auch auf diesem Kühlelement schon kontaktiert und zur weiteren Verschaltung auf Modulebene Kontaktbereiche zur Verfügung gestellt. Eine typische Solarzellenbaugruppe nach dem Stand der Technik (dokumentiert z.B. in J. Jaus, U. Fleischfresser, G. Peharz et al., "Heat Sink Substrates for Automated Assembly of Concentrator Modules", Proc. of 21st European Photovoltaic Solar Energy Conference, 2006, S. 2120-2123 oder A.W. Bett, C. Baur, F. Dimroth et al., "FLATCON™-modules: Technology and Characterisation", Proc. of 3rd World Conference on Photovoltaic Energy Conversion, 2003, S. 634-637 oder US 5,167,724) besteht aus einer Solarzelle, einem Substrat zur Wärmeleitung (z.B. Kupfer), mehreren aufgebrachten Metallschichten zur Verbesserung der Kontaktierbarkeit, einer Lot- oder Kleberschicht zur Kontaktierung der Solarzellenrückseite sowie gebondete oder geschweißte Kontaktierungen der Solarzellenoberseite.

Die beiden Pole der Solarzelle werden jeweils mit einer der Metallschichten elektrisch verbunden. Hierzu wird der flächig ausgeführte Rückseitenkontakt der Solarzelle flächig mit einer ersten Metallschicht verbunden. Der Vorderseitenkontakt der Solarzelle wird mit einer zweiten Metallschicht verbunden. Da sich auf der Frontseite der Solarzelle neben dem Vorderseitenkontakt auch die aktive Fläche der Zelle befindet, ist der Vorderseitenkontakt vorzugsweise sehr klein im Vergleich zur aktiven Fläche ausgeführt, um möglichst viel des eingestrahlten Sonnenlichts zur Stromgeneration nutzen zu können. Daher wird die Verbindung zum Frontseitenkontakt zumeist durch einen sehr dünnen Bonddraht (ca. 50 pm) durchgeführt. Neben der elektrischen Verschaltung übernimmt das SCA die Aufgabe der Ableitung der anfallenden Verlustwärme. Diese Funktion einer Wärmesenke beinhaltet zum ersten die Übertragung der Wärmeenergie von der Zelle an die verschiedenen Metallschichten des SCA (insbesondere über den flächigen Rückseitenkontakt an den damit verbundenen Metallschichten) sowie die Übertragung der Wärme an die Modulrückseite. Zum anderen ist eine "Wärmespreizung" notwendig, d.h. die Verteilung der Wärme auf eine größere Fläche. Dies ist besonders bei hochkonzentrierenden Systemen notwendig, bei der eine relativ hohe Strahlungsdichte und damit auch Wärmedichte erreicht wird. Einzelne Solarzellenbaugruppen sind im Stand der Technik auf eine Modulbodenplatte montiert. Diese Modulbodenplatte leitet die Wärmeenergie an die Umgebung ab. Die einzelnen SCAs werden auf diese Modulbodenplatte so montiert, dass die Solarzelle sich möglichst genau im Brennpunkt der darüber montierten Linsenplatte (oder eines anderen optischen Systems zur Konzentration von solarer Strahlung befindet). Nach der Montage der SCAs auf der Bodenplatte findet auch die elektrische Verschaltung der SCAs untereinander statt. Je nach gewünschter Modulspannung können Serienverschaltung und Parallelverschaltung miteinander kombiniert werden. Die Bodenplatte muss hierzu isolierend ausgeführt sein, da sonst schon die Montage der SCAs zu einer Parallelverschaltung aller SCAs eines Moduls führen würde, was zur Generierung besonders hoher Ströme führen würde und aufgrund der hierdurch entstehenden ohmschen Verluste unerwünscht ist.

In Hinblick auf die Realisierung von Modulbodenplatten unter Verwendung von Solarzellenbaugruppen nach dem Stand der Technik sind folgende Nachteile zu nennen:
- Die Solarzellenbaugruppen benötigen zur Spreizung der in der Solarzelle anfallenden Wärme eine relativ große Fläche. Kupfer ist aufgrund seiner guten Wärmeleitfähigkeit das am häufigsten verwendete Basis-Material für diese Aufgabe. Durch den hohen Kupferpreis fallen dadurch sehr hohe Materialkosten an.
- Die Rückseite der Solarzelle kann nicht direkt auf Kupfer geklebt oder gelötet werden. Dazu werden noch weitere metallische Schichten benötigt. Nickel als Diffusionsbarriere gefolgt von einer dünnen Goldschicht sind übliche Kombinationen. Der hierzu notwendige galvanische Prozessschritt verursacht bedingt durch die große flächige Ausdehnung hohe Material- und Prozesskosten. Durch die Verwendung von Masken können zwar diese Kontaktmetalle nur an den Stellen aufgetragen werden, an denen sie auch benötigt werden, jedoch muss dennoch die gesamte Fläche der SCAs durch die Galvanik-Anlage geführt werden und erhöht so die Prozesskosten.
- Zur Montage der Solarzelle auf der Wärmesenke sowie zur Kontaktierung der Solarzellenvorderseite werden Anlagen aus der Mikroelektronikproduktion verwendet. Diese Anlagen sind speziell dafür ausgelegt, mit hoher Geschwindigkeit integrierte Schaltkreise zu kontaktieren. Durch die relativ große Fläche der Solarzellenbaugruppen wird in der Praxis der Durchsatz an diesen Anlagen spürbar reduziert. Nicht mehr die Bearbeitungsgeschwindigkeit beeinflusst den Durchsatz an einer entsprechenden Anlage, sondern die Geschwindigkeit in der die SCAs ein- und ausgefahren werden können.
- Das nach dem Stand der Technik bisher häufig eingesetzte Bodenplattenmaterial Glas ist zwar sehr kostengünstig, hat aber nur einen relativ kleinen Wärmeleitungskoeffizient (<2 W/mK). Dadurch kann die Bodenplatte nur sehr schlecht eine Wärmespreizungsfunktion übernehmen, sondern lediglich die Wärme von einem großflächig ausgeführten SCA an die Außenluft durchleiten.
- Da die Solarzelle nach dem Stand der Technik wie oben beschrieben mit dem Rückseitenkontakt direkt auf die Kupferfläche montiert wird, muss die Solarzellenoberseite auf eine zweite, elektrisch isolierte, Fläche kontaktiert werden. Hierzu muss die Solarzellenbaugruppe selbst in Multilayertechnik ausgeführt werden (J. Jaus, U. Fleischfresser, G. Peharz et al., "Heat Sink Substrates for Automated Assembly of Concentrator Modules", Proc. of 21st European Photovoltaic Solar Energy Conference, 2006, S. 2120-2123, oder sie muss ein Kontaktierungspad aufweisen. Beides verursacht zusätzliche Material- und Prozesskosten.

Auch dem Solarzellenmodul der WO 91/18420 A haften einige dieser Nachteile an, da die Trägerstruktur 42 in diesem Solarzellenmodul elektrisch leitfähig ist und es keine Strategie für eine effiziente Wärmespreizung gibt.

Desweiteren sind nach dem Stand der Technik Ausführungsformen bekannt, bei der die Bodenplatte selbst mehrere Metallschichten aufweist (US 6,248,949 B1 und WO 91/20097). Diese Metallschichten werden jeweils mit der Solarzellenvorderseite bzw. Rückseite direkt verbunden. Diese Bodenplatten werden zumeinst in Leiterplattentechnologie ausgeführt, in der mehrer leitende (z.B. Cu) und nichtleitende (z.B. Glasfaser-Epoxidharz) Metallschichten durch Laminieren miteinander verbunden werden. Zur Erzeugung einer Serienverschaltung werden die Layer dabei durch einen photolithographischen Strukturierungsprozess strukturiert und so elektrisch voneinander isolierte Bereiche geschaffen, die dann über die Solarzellen miteinander verbunden werden.

In Hinblick auf die Realisierung von Modulbodenplatten unter Verwendung der Multischichttechnologie nach dem Stand der Technik sind folgende Nachteile zu nennen:
- Als Leitungsschicht können verschieden dicke Metallschichten eingesetzt werden, typischerweise wird Kupfer in Dicken von 0,035 bis 0,5 mm eingesetzt. Typischerweise ist mindestens eine der Schichten dicker ausgelegt (>200 µm) um die Wärmespreizung durchzuführen. Jedoch können nicht alle Solarzellen direkt auf dieser Wärmeleitungsschicht aufgesetzt werden, da hierdurch eine Parallelschaltung aller dieser Zellen stattfinden würde, mit den beschriebenen negativen Folgen. Die Solarzelle muss also auf einer elektrisch leitfähigen Schicht montiert werden, die aber von dieser Haupt-Wärmeleitungsschicht isoliert sein muss. Als Isolierungsmaterial kommen im Stand der Technik meistens epoxydharzgetränkte Glasfasergewebe zum Einsatz (z.B. FR4). Auf diesem Material basieren auch fast alle auf dem Markt erhältlichen Leiterplatten. Auch wenn diese Schicht mit einer fortschrittlichen Multischicht-Technik sehr dünn ausgeführt werden kann (<100 µm), ergibt sich dennoch, bedingt durch den kleinen Wärmeleitkoeffizient von FR4 (<1 W/mK), ein sehr hoher thermischer Widerstand.
- Der Einfluss dieses großen thermischen Widerstands ist als besonders hoch zu bewerten, da die Verlustwärme an dieser Stelle noch nicht gespreizt wurde, d.h. ein hoher Wärmefluss auf sehr kleiner Querschnittsfläche stattfindet. Gemäß der Wärmeleitungsgleichung nach Fourier führen diese beiden Faktoren zu einer unerwünscht hohen Zelltemperatur.
- Zur Erzeugung einer Serienverschaltung muss zumindest eine Leitungsschicht strukturiert werden, d.h. in einzelne elektrisch isolierte Bereiche aufgetrennt werden. Hierzu werden nach dem Stand der Technik photolithographische Strukturierungsmethoden angewandt. Hierzu wird eine Photomaske belichtet, entwickelt und das Kupfer an den entsprechenden Stellen abgeätzt. Dieser Prozess ist relativ kostenaufwändig, insbesondere da er auf der gesamten Fläche der Modulbodenplatte durchgeführt werden muss.

Ausgehend hiervon war es Aufgabe der vorliegenden Erfindung, Solarzellenmodule bereitzustellen, die die beschriebenen Nachteile des Standes der Technik beseitigen und einfach und kostengünstig herstellbar sind.

Diese Aufgabe wird durch das Solarzellenmodul mit den Merkmalen des Anspruchs 1 und das Konzentrator-Solarzellenmodul mit den Merkmalen des Anspruchs 18 gelöst. Die weiteren abhängigen Ansprüche zeigen vorteilhafte Weiterbildungen auf.

Erfindungsgemäß wird ein Solarzellenmodul bereitgestellt, das mindestens zwei miteinander verschaltete Solarzellen aufweisende Baugruppen (SCAs) sowie eine Modulbodenplatte enthaltend eine elektrisch leitfähige Trägerstruktur und eine gegenüber der Trägerstruktur elektrisch isolierte Rückseitenplatte aufweist. Diese Trägerstruktur weist dabei voneinander getrennte mit Solarzellenbaugruppen bestückte Bereiche (SCA-Bereiche) sowie Verschaltungsbereiche aufweist und eine Verschaltung der Solarzellenbaugruppen durch eine elektrische Kontaktierung der SCA-Bereiche mit der Vorderseite einer benachbarten Solarzelle sowie durch eine elektrische Kontaktierung der SCA-Bereiche mit jeweils einem benachbarten Verschaltungsbereich als serielle Schaltung oder von SCA-Bereichen untereinander und Verschaltungsbereichen untereinander als parallele Schaltung erfolgt.

Im Gegensatz zum Stand der Technik, in dem das SCA sowohl die elektrische Kontaktierung als auch die Wärmespreizung übernimmt, sind diese Funktionalitäten erfindungsgemäß aufgeteilt. Das SCA übernimmt vor allem die elektrische Kontaktierung der Solarzelle sowie eine erste Wärmespreizung im kritischen Bereich von wenigen mm um die Zelle. Dadurch kann das SCA deutlich kleiner ausfallen. So beträgt die Fläche der Trägerstruktur aufgrund der zweistufigen Wärmespreizung in der Regel weniger als die Hälfte der gesamten Solarzellenmodulfläche, teilweise gar nur ein Viertel der Solarzellenmodulfläche. Die eigentliche Wärmespreizung auf eine möglichst große Fläche übernimmt erfindungsgemäß die Rückseitenplatte, die aufgrund ihrer elektrisch isolierten Verbindung zum SCA als beispielsweise durchgängige Folie ausgeführt sein kann und so keinerlei Strukturierungsaufwand erfordert. Es handelt sich somit um eine zweistufige Wärmespreizung, bei der zunächst eine erste Wärmespreizung über den SCA-Bereich und anschließend eine zweite Wärmespreizung über die Rückseitenplatte erfolgt.

Erfindungsgemäß kann eine Entkopplung von Wärmespreizungsfläche und elektrischer Verschaltungsfläche durch die beschriebenen Bereiche ermöglicht werden. Die elektrische Verschaltungsfunktionalität wird erfindungsgemäß somit von der Trägerstruktur mit übernommen.

Vorzugsweise ist die Trägerstruktur monolithischen Ursprungs und eine Trennung der Bereiche ist durch Freistanzen erfolgt.

Die Trägerstruktur kann sowohl ein Trägerband oder auch eine Trägerplatte sein. Vorzugsweise besteht sie aus einem metallischen Bandmaterial mit einer Dicke im Bereich von 0,1 bis 5 mm, insbesondere 0,2 bis 0,5 mm. Gleichzeitig sollte die Trägerstruktur eine hohe thermische und elektrische Leitfähigkeit besitzen. Besonders geeignet ist hierfür Kupfer mit niedrigen Legierungsanteilen von Eisen oder Nickel. Diese Trägerstruktur wird dann z.B. durch Stanzen einzelner Bereiche strukturiert, die zunächst alle über Stege (sog. Stanzbrücken) miteinander verbunden sind. Es entstehen dabei SCA-Bereiche, auf denen später die Solarzelle montiert wird. Weiter werden Verschaltungsbereiche gebildet, die später als Verschaltungsplattform dienen. Optional ist es auch möglich, dass dritte Bereiche entstehen, die Hilfselemente wie eine Lochmaske zur Indexierung des Metallstreifens in den Prozessanlagen aufweisen.

In einer bevorzugten Ausführungsform kann zur besseren elektrischen Kontaktierbarkeit die Trägerstruktur ganzflächig oder auch nur bereichsweise an den benötigten Stellen mit weiteren metallischen Schichten versehen sein. Diese Metalle dienen dann z.B. als Diffusionssperren, z.B. Nickel, Palladium oder Silber, oder als Oxidationsbarriere, z.B. Gold.

Vorzugsweise wird die Solarzelle mit Hilfe eines elektrisch leitfähigen Klebstoffs oder mittels Lot über den flächigen Rückseitenkontakt mit der Trägerstruktur im SCA-Bereich verbunden. Die Vorderseitenkontakte der Solarzelle können anschließend mit einem Verschaltungsbereich der Trägerstruktur durch elektrische Kontaktierung, z.B. durch Dünndrahtbonden, verbunden werden. Anschließend kann die so montierte und kontaktierte Solarzelle z.B. mittels eines Spritzgussverfahrens eingekapselt werden. Durch diesen Schritt werden gleichzeitig die SCA-Bereiche und die Verschaltungsbereiche miteinander mechanisch verbunden. Wird dieser Spritzguss-Schritt ausgelassen, so kann auch eine mechanische Verbindung alternativ über ein Fixierungsband oder ein geklebtes oder gelötetes Hilfselement erfolgen.

Anschließend kann ein Freistanzen der nun zusätzlich durch den Verguss miteinander verbundenen SCA-Bereiche und Verschaltungsbereiche durch Auftrennen der Stanzbrücken durchgeführt werden. Die nach diesem Schritt vorliegenden einzelnen SCAs können nun ggf. noch einer Qualitätssicherung, z.B. durch Kennlinienmessung, unterworfen werden und so anschließend zur Montage auf der Rückseitenplatte bereit.

Eine andere Alternative sieht vor, dass die Verschaltungsbereiche, d.h. die Verschaltungsplattform, auch auf einer separaten Trägerstruktur, z.B. einem Metallstreifen, hergestellt werden kann. In diesem Fall entfällt zunächst die Kontaktierung der Solarzellenoberseite. Diese findet dann erst nach der Montage der SCA-Bereiche und der Verschaltungsbereiche auf der Rückseitenplatte statt.

Die Rückseitenplatte besteht vorzugsweise aus einem thermisch gut leitenden (k > 50 W/mK) Metallblech der Dicke 0,1 bis 5 mm, besonders bevorzugt 0,2 bis 0,5 mm. Vorzugsweise besteht die Rückseitenplatte aus einer Aluminiumlegierung.

Die SCAs werden auf diese mit einer Eloxalschicht versehenen Aluminiumplatte mittels eines thermisch gut leitfähigen Klebstoffs mit einer Wärmeleitfähigkeit im Bereich von 0,2 bis 50 W/mK, besonders bevorzugt > 1,5 W/mK montiert. Die elektrische Verschaltung untereinander erfolgt durch eine elektrische Verbindung zwischen den SCA-Bereichen und den Verschaltungsbereichen. Zur Erzielung einer Serienverschaltung werden abwechselnd Elemente des SCA-Bereichs mit dem Verschaltungsbereich verschaltet.

Eine derartig gestaltete Modulbodenplatte wird vorzugsweise über eine Rahmenkonstruktion mit einer Linsenplatte zu einem fertigen Modul verbunden. Neben der Verwendung einer Rahmenkonstruktion bietet es sich hier an, dass die Rückseitenplatte bzw. die zur mechanischen Stabilisierung eingesetzte Substratplatte durch Umformung, z.B. Tiefziehen, derart ausgeformt wird, dass sie die Funktionalität des Rahmens mit übernehmen kann und die Linsenplatte dann direkt mit dieser Platte verbunden wird. Werden zur Materialeinsparung besonders dünne Rückseitenplatten eingesetzt, so können diese auf eine Substratplatte aus einem mechanisch stabilen Material, z.B. Stahl, Kunststoffe, Glas, Glasfaserverbundwerkstoffe, aufgebracht werden.

Im Folgenden werden nochmals bevorzugte Ausgestaltungen des erfindungsgemäßen Gegenstands aufgeführt.

Die Realisierung der Rückseitenplatte kann aus einem Element bestehen (z.B. eine eloxierte AluminiumPlatte der Stärke 2 mm) oder auch über mehrere Elemente realisiert werden. Hier bietet sich vor allem die Realisierung über eine relativ dünne Metallfolie an, vorzugsweise aus Aluminium mit einer Dicke von ca. 100 bis 300 µm, die im Roll-to-Roll-Verfahren kostengünstig mit einer Isolationsschicht versehen werden kann, z.B. durch anodisches Eloxal, aufgedampfte Oxidschicht, plasmagestützte Auftragsverfahren von anorganischen Verbindungen, Aufkleben/Laminieren einer Isolatorfolie oder Belackung im Walz- oder Sprühverfahren.

Diese Folie kann dann auf eine stabile Rahmenkonstruktion aufgespannt werden, z.B. bestehend aus einem zweifach abgekanteten Blechband. Alternativ dazu kann durch das Auflaminieren auf einem mechanischen stabilen Trägersubstrat, z.B. verzinktem Stahl, Glas, Faserverbundwerkstoffen, Laminaten oder Aluminium, eine selbsttragende Konstruktion erzielt werden.

Die Bodenplatte ist vorteilhafter als selbsttragende Blechkonstruktion realisiert. Dies bedeutet in diesem Zusammenhang, dass die notwendige mechanische Stabilität nicht, wie es beim Stand der Technik üblich ist, ausschließlich durch Materialstärke erzielt wird, sondern durch eine geeignete Formgebung der Rückseitenplatte. Dies kann z.B. durch die Ausbildung von Sicken, Verstärkungsfalzen, Abkantungen realisiert werden.

Soll das Modul hermetisch dicht ausgeführt werden, so weist die Modulbodenplatte vorteilhafter Weise einen effektiven E-Modul auf, der das 0,1- bis 2-fache, besonders bevorzugt das 0,2- bis 0,8-fache, der Linsenplatte beträgt. Dies kann z.B. durch eine geeignete Dicke und Materialwahl der Rückseitenplatte erzielt werde. Hierdurch wird der bei einer bestimmten Modultemperatur erreichte Druck im Innern des Moduls stärker durch die Bodenplatte als durch die Linsenplatte abgebaut. Die Bodenplatte übernimmt dann die Funktion einer Druckmembran. Hierdurch kann die Auslenkung der Linsenplatte verringert, und damit das sog. Off-Pointing, d.h. das Herauslaufen des Fokuspunktes aus der aktiven Zellfläche, vermieden werden.

Zur Verbesserung der Membranfunktion verfügt die Modulbodenplatte hierzu über spezielle Bereiche im Randbereich des Moduls, in der die Elastizität erhöht ist. Dies wird vorteilhafterweise über eine verringerte Materialdicke oder durch spezielle Ausformungen wie doppelte Abkantungen realisiert.

Zur Ableitung der in der Solarzelle anfallenden Verlustwärme sowie zu deren Verteilung auf eine größere Fläche werden mehrere Materialien eingesetzt. Dabei sind diese Materialien so gewählt, dass der Wärmeleitungskoeffizient k am höchsten für diejenigen Materialien ist, die in unmittelbarer Nähe der Solarzelle verwendet werden. Hierbei ist der Einsatz thermisch sehr gut leitender Materialien aufgrund der noch sehr hohen thermischen Flussdichte besonders wichtig. Mit zunehmender Vergrößerung des Leitungsquerschnitts kann dann auch die Wärmeleitfähigkeit sinken, ohne dass es zu einem Wärmestau kommen kann. Im Vergleich zum Stand der Technik, bei dem ein einziges Material/Element als Heatsink eingesetzt wird, kann hierdurch eine starke Reduktion des Materialeinsatzes bzw. der Materialkosten erreicht werden.

Beispielhaft sei hier folgende Materialkombination einer erfindungsgemäßen Realisierung der Bodenplatte genannt:
a. SCA-Bereiche der Trägerstruktur: Kupferlegierung, Wärmeleitfähigkeit ~380 W/mK
b. Eloxierte Aluminiumplatte: Aluminiumlegierung, Wärmeleitfähigkeit -210 W/mK
c. Verzinkte Stahlträgerplatte: Legierter Stahl, Wärmeleitfähigkeit -40 W/mK

Zwischen der Solarzelle und den Elementen zur Wärmeableitung, bzw. zwischen den einzelnen Elementen zur Wärmeableitung werden Verbindungsmaterialien eingesetzt, die ebenfalls nach dem Prinzip des "Graded Heat Transfer Coefficient" ausgewählt sind. Dadurch kann der Einsatz von besonders gut leitenden (und daher meistens auch teureren) Verbindungsmaterialien auf ein Minimum beschränkt werden. Beispielhaft sei hier folgende Abstufung genannt:
a. Verbindung Zelle zu SCA-Bereichen der Trägerstruktur:
   Silbergefüllter Leitkleber mit k ~5 W/mK
b. Verbindung SCA-Bereiche der Trägerstruktur zur eloxierten Aluminiumplatte:
   Aluminiumhydroxid gefülltes Epoxydharz mit k -1,5 W/mK
c. Verbindung eloxierte Aluminiumplatte zu mechanischem Träger:
   Ungefülltes Epoxydharz mit k ~0,2 W/mK

Analog zur abgestuften thermischen Leitfähigkeit werden die Materialien zur Minimierung von Spannungen aufgrund unterschiedlicher thermischer Ausdehnung möglichst nach einem abgestuften thermischen Expansionskoeffizienten (CTE - Coefficient of Thermal Expansion) ausgewählt:
a. Als Solarzellsubstrat findet Silizium oder Germanium mit einem CTE von 2,6 ppm/°K bzw. 5,8 ppm/°K Verwendung
b. Dieses Substrat wird auf eine Trägerstruktur aus Kupfer montiert, CTE von Kupfer ist 16,7 ppm/°K.
c. Die eloxierte Aluminiumplatte hat einen CTE von 23 ppm/°K

Im Gegensatz zum Stand der Technik, bei dem zwei verschiedene elektrisch voneinander isolierte Layer eingesetzt werden, werden beim Erfindungsgegenstand beide elektrischen Bereiche auf nur einer Trägerstruktur realisiert (SCA-Bereiche und Verschaltungsbereiche). Durch eine geeignete Vergusstechnik/Freistanztechnik sowie durch den Einsatz einer isolierten Rückseitenplatte lässt sich dadurch deutlich einfacher die gewünschte Serienverschaltung erreichen.

Bei der Formgebung der SCA-Bereiche und der Verschaltungsbereiche der Trägerstruktur bestehen zwei sich gegenseitig beeinflussende Zielstellungen: Um die Bonddrahtlänge möglichst kurz zu halten, sollte der Verschaltungsbereich möglichst nah an den SCA-Bereich herangeführt werden. Dies beeinträchtigt jedoch die radiale Wärmeableitung von der Zelle, da die SCA-Bereiche und Verschaltungsbereiche ja nach dem Freistanzen nicht mehr miteinander über die Metallstreifenfläche verbunden sein dürfen. Daher wird der Verschaltungsbereich vorteilhafter Weise als Zunge gestaltet, die leicht in den SCA-Bereich hineinragt. Als optimaler Kompromiss zwischen Bonddrahtlänge und Einschränkung der Wärmeleitung sollte der minimale Abstand zur Zellfläche zwischen 1 und 10 mm (besser zwischen 2 und 5 mm) betragen.

Die Rückseitenplatte kann über eine doppelte Isolierung verfügen. Für das Erreichen von hohen Systemspannungen (in aktuellen Systemen ~800 V) ist eine gute Isolierung zu gewährleisten. Um hier die notwendige sichere Isolierung zu gewährleisten, ist die Rückseitenplatte mit einer doppelten Isolierung versehen:
a. 1. Isolation in Richtung SCA (innenliegende Isolationsschicht)
b. 2. Isolation in Richtung Außenluft bzw. zweiter Rückseitenplatte (außenliegende Isolationsschicht)

Diese doppelte Realisierung der Isolationsschichten kann bei Verwendung von Aluminium sehr kostengünstig durch ein allseitig durchgeführtes Eloxalverfahren realisiert werden, bei dem das Aluminium in den oberflächennahen Bereichen in einem sauren Elektrolytbad zu Aluminiumoxid umgewandelt (elektrisch oxidiert) wird.

Weitere Isolationsschichten bieten sich an, in Richtung SCA durch einen elektrisch nicht-leitenden Klebstoff. Dieser wird vorteilhafterweise durch den Auftrag einer entsprechenden Schicht bereits vor der Vereinzelung durchgeführt. Direkt nach dem Auftrag wird diese Schicht schon teilweise vorpolymerisiert, sodass sie bei Raumtemperatur nicht mehr klebrig ist. Beim Bestückungsprozess wird diese Schicht dann vollends durchpolymerisiert und bildet eine feste Verbindung zwischen Trägerstruktur des SCA und Rückseitenplatte.

Weitere Isolationsmöglichkeiten bestehen in Richtung verstärkender Subratplatten durch einen nicht-leitenden Klebstoff sowie auf der Modulrückseite durch einen elektrisch isolierenden Tauchlack.

Nachdem die Solarzelle und die Schutzdiode auf dem SCA-Bereich montiert wurden ("Die-Attach") sowie der Drahtbondprozess zum Verschaltungsbereich abgeschlossen ist, bietet sich die Einkapselung dieser Halbleiterchips sowie der Drahtbondverbindungen an. Hierdurch wird ein Schutz der Kontakte sowie der empfindlichen Solarzellenränder gegen feuchtigkeitsbedingte Korrosion erzielt. Wird eine nicht-transparente Verkapselungsmasse gewählt, so wird der aktive Bereich der Solarzelle ausgespart. Als Vergussverfahren kommen sowohl Dispensen als auch Spritzguss in Betracht.

Bei geeigneten transparenten (Absorption < 20 % von 400-2000 µm Wellenlänge) Einkapselungsmaterialien wird beim Spritzgussverfahren vorteilhafter Weise gleich direkt über der Zelle eine sogenannte Sekundäroptik ausgeformt, die den Strahlengang des Sonnenlicht so beeinflusst, dass auf der Solarzelle ein höherer durchschnittlicher Strahlungsfluss erzielt werden kann. Dies kann beispielsweise durch die Ausformung einer Linse oder eines auf interner Reflektion basierenden Trichters erfolgen.

Die nicht-transparente Einkapselung weist vorteilhafter Weise Ausformungen auf, die zur Befestigung einer reflektiven Sekundäroptik dienen, z.B. Laschen für Klick-Montage.

Entscheidend für eine niedrige Zelltemperatur ist die Erzielung einer effizienten Wärmeabgabe an die Umgebung. Der Anteil der Wärmestrahlung ist dabei relativ groß. Daher weist der Erfindungsgegenstand vorteilhafter Weise folgende Elemente auf:
a. Eine Schicht mit hoher Emissivität im Bereich 2.000-10.000 µm auf der Oberseite der Rücksei tenplatte. Die Verwendung von eloxiertem Aluminium für diesen Zweck ist hier vorteilhaft, da die Eloxalschicht schon automatisch eine hohe Emissivität in diesem Bereich aufweist. Durch eine hohe Infrarot-Emissivität der Oberseite der Rückseitenplatte wird die Abstrahlung zur Linsenplatte vergrößert. Dadurch dehnt sich die Linsenplatte stärker aus, was aufgrund der ebenfalls relativ hohen Bodenplattenausdehnung positiv zu bewerten ist. Außerdem kann die Linsenplatte in den Weltraum abstrahlen, wodurch sich ein höherer Nettostrahlungstransfer ergibt als bei der Modulbodenplatte, die mit dem Erdboden im Strahlungsaustausch steht.
b. Eine Schicht hoher Emissivität im Bereich 2.000 - 10.000 µm auf der Unterseite der Bodenplatte (z.B. Lack, Folie) . Wird Aluminium als Material auf der Rückseite verwendet, so ist auch hier die Eloxalschicht für diesen Zweck vorteilhaft.

Zur Erhöhung der teilweise schon in den Grundmaterialien vorhandenen Infrarot-Emissivität können auch Beschichtungen und Lack verwendet werden. Vorteilhafterweise sind hier dünne Schichten aus SiO₂ zu nennen, oder auch Ölfarbenanstriche.

Die Schichten zur Anbindung der Solarzelle an die SCA-Bereiche der Trägerstruktur werden vorteilhafterweise über eine Lotverbindung auf Basis von SnPb, SnAg, AnAgCu bzw. über einen Leitkleber auf Basis von Epoxydharzen, Silikonen oder Thermoplasten mit silber- oder kupferbasierten Füllstoffen realisiert.

Die Schicht zur Anbindung der Solarzellenbaugruppe auf die Rückseitenplatte wird vorteilhafterweise aus Epoxidharz, Acrylat, Kapton, Silikonkleber oder einem Thermoplast mit Füllstoffen Aluminiumoxid, Aluminiumhydroxid oder Boroxid, Aluminiumnitrid, Bornitrid realisiert.

Alternativ hierzu kann auch auf die Rückseite des Leadframes eine Schicht nichtleitender Kunststoff (auch in Form von teilvernetzten Epoxidharzen oder anderen teilausgehärteten Klebstoffen) verwendet werden. Diese Schicht liegt bei Raumtemperatur als Film vor und wird zunächst mit der Rückseite des Leadframes verbunden. Hierdurch werden die einzelnen Bereiche der Trägerstruktur auch beim Freistanzen zusammengehalten. Nach dem Freistanzen können die SCAs dann mittels dieser Schicht fest mit der Bodenplatte verbunden werden. Diese Schicht kann auch die Aufgabe der elektrischen Isolierung mit übernehmen.

Die elektrische Kontaktierung der Solarzellenbaugruppen zur modulinternen Verschaltung wird vorteilhafter Weise über folgende Technologien realisiert:
a. Ultraschall-Dickdraht mit Aludrähten
b. Thermokompressionsbonden mit Cu,
c. Schweißverfahren von Cu- oder Al-Bändern oder Drähten
d. Kontakt nur durch Klebung

Zur Kontaktierung nur durch Klebung ist auf der Isolationsschicht der Rückseitenplatte ein Netzwerk aus metallischen Leiterbahnen aufgebracht, z.B. durch Tiefdruck, Siebdruck oder Inkjet-Verfahren.

Dieses Netzwerk aus Leiterbahnen kann zur Verbesserung der Stromleitung durch galvanische oder stromlose Verfahren verstärkt werden.

Vorteilhafter Weise werden in die Bodenplatte geeignete Elemente zur Befestigung (z.B. Bohrungen, Gewindeeinsätze), sowie weitere Verschaltungselemente, Anschlussdosen, Montageelemente integriert.

Anhand der nachfolgenden Figuren soll der erfindungsgemäße Gegenstand näher erläutert werden, ohne diesen auf die hier gezeigten speziellen Ausführungsformen einschränken zu wollen.

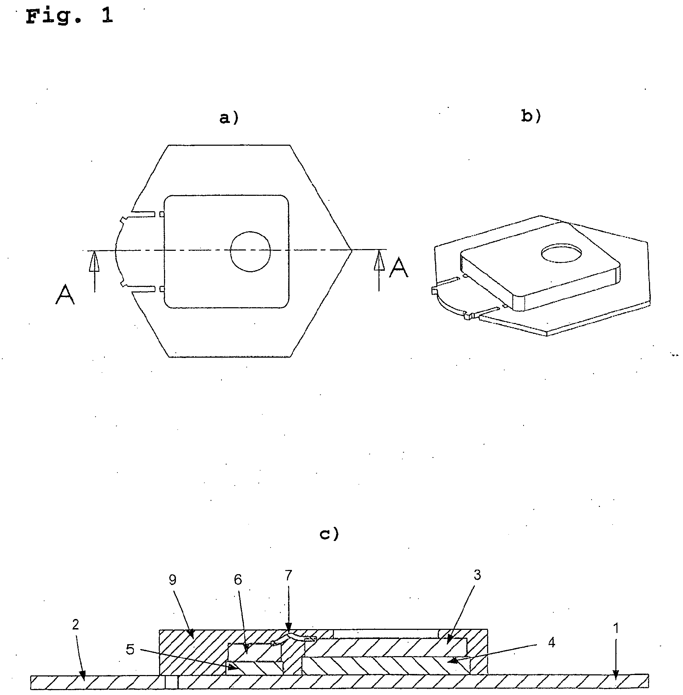

Fig. 1 zeigt eine Aufsicht (Fig. 1a), eine Perspektive (Fig. 1b) und einen Schnitt (Fig. 1c) einer erfindungsgemäßen Solarzellenbaugruppe mit Vergussmasse. Die Trägerstruktur weist hier den Solarzellenbaugruppen-bestückten Bereich 1 und einen Verschaltungsbereich 2 auf, die voneinander zumindest teilweise räumlich getrennt sind. Auf dem SCA-Bereich 1 ist eine Solarzelle 3 mittels eines Leitklebers oder Lotes angekoppelt. Weiterhin ist eine Schutzdiode 6 mittels eines Leitklebers oder Lotes auf dem SCA-Bereich 1 angeordnet. Solarzelle 3 und Schutzdiode 6 sind z.B. über Dünndraht-Bonds 7 miteinander kontaktiert. In Fig. 1 ist dieses Solarzellemodul in eine Vergussmasse 9 eingeschlossen.

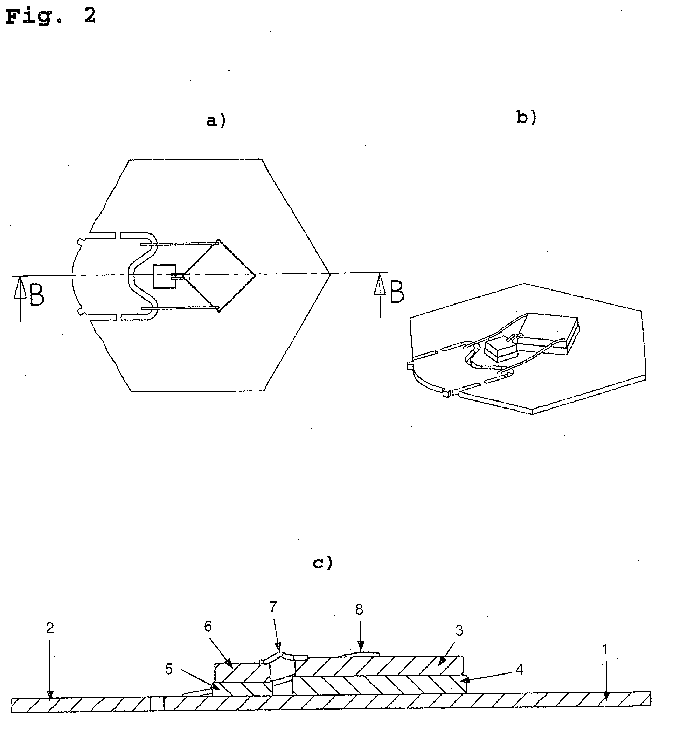

In Fig. 2 ist eine Aufsicht (Fig. 2a), eine Perspektive (Fig. 2b) und ein Schnitt (Fig. 2c) des erfindungsgemäßen Solarzellenmoduls dargestellt. Hierbei handelt es sich um eine Variante ohne Vergussmasse. Die Bezugszeichen entsprechen denen aus Fig. 1, wobei in dieser Zeichnung zusätzlich die Kontaktierung der Solarzellenvorderseite mittels Dünndraht-Bonds 8 zu erkennen ist.

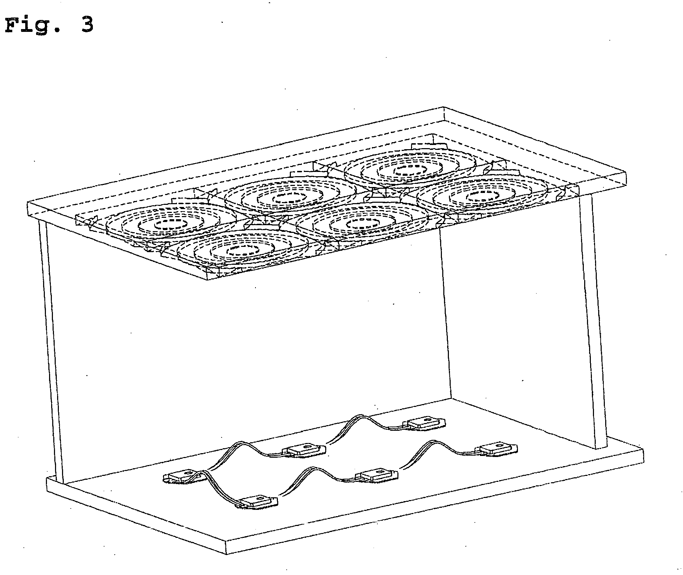

In Fig. 3 ist beispielhaft eine Verschaltung von sechs erfindungsgemäßen Solarzellenbaugruppen dargestellt.

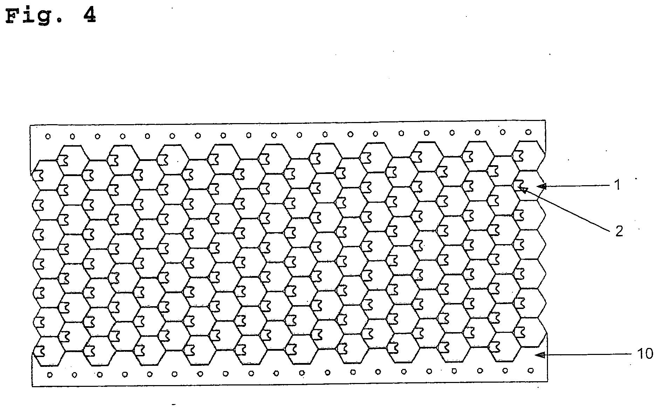

Fig. 4 zeigt ein Chip-Trägerband mit SCA-Bereichen 1, Verschaltungsbereichen 2 sowie dritten Bereichen, die Hilfselemente, wie eine Lochmaske zur Indexierung des Metallstreifens in den Prozessanlagen aufweisen können.

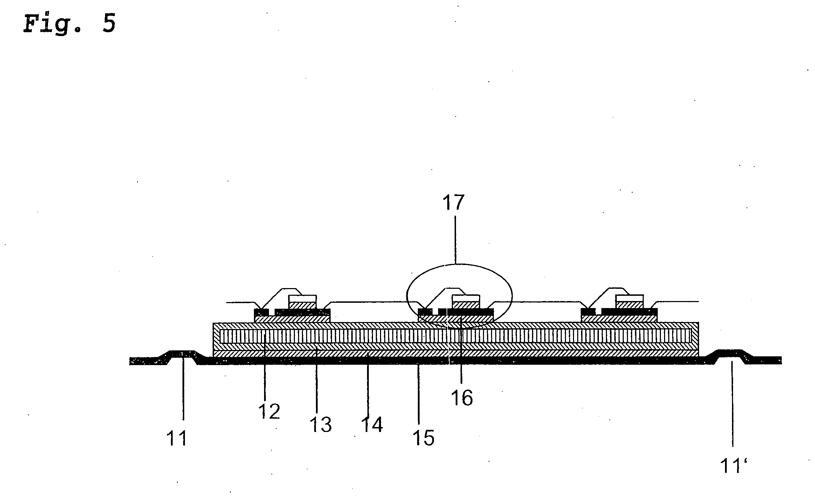

Fig. 5 zeigt die Anordnung erfindungsgemäßer Solarzellenmodule. Die Rückseitenplatte 12, z.B. aus Aluminium, weist hier auf den Oberflächen eine Isolationsschicht 13, z.B. eine Eloxalschicht, auf. Diese Rückseitenplatte ist mittels eines Verbindungsmaterials 14 mit einer zweiten Rückseitenplatte, z.B. einer lackierten Stahlplatte, gekoppelt. Diese zweite Rückseitenplatte kann weitere funktionelle Elemente, z.B. Verstärkungssicken 11 und 11' aufweisen. Die SCA 17 ist über ein Verbindungsmittel 16 mit der Rückseitenplatte verbunden.

## Patentansprüche

1. Solarzellenmodul enthaltend mindestens zwei miteinander verschaltete, Solarzellen (3) aufweisende Baugruppen (SCA, 17) sowie eine Modulbodenplatte enthaltend eine elektrisch leitfähige Trägerstruktur und eine gegenüber der Trägerstruktur elektrisch isolierte Rückseitenplatte (12), wobei die Trägerstruktur voneinander getrennte mit Solarzellenbaugruppen bestückte Bereiche (SCA-Bereiche, 1) sowie Verschaltungsbereiche (2) aufweist und eine Verschaltung der Solarzellenbaugruppen durch eine elektrische Kontaktierung der SCA-Bereiche (1) mit der Vorderseite einer benachbarten Solarzelle (3) sowie durch eine elektrische Kontaktierung der SCA-Bereiche (1) mit jeweils einem benachbarten Verschaltungsbereich (2) als serielle Schaltung oder von SCA-Bereichen (1) untereinander und Verschaltungsbereichen (2) untereinander als parallele Schaltung erfolgt und wobei eine zweistufige Wärmespreizung mit einer ersten Wärmespreizung über den SCA-Bereich (1) und einer zweiten Wärmespreizung über die Rückseitenplatte (12) erfolgt.

2. Solarzellenmodul nach Anspruch 1,
**dadurch gekennzeichnet, dass** die Trägerstruktur monolithischen Ursprungs ist und die Trennung der Bereiche (1,2) durch Freistanzen erfolgt ist.

3. Solarzellenmodul nach einem der vorhergehenden Ansprüche,
**dadurch gekennzeichnet, dass** die Solarzellen (3) mit der Trägerstruktur stoffschlüssig, insbesondere mittels eines Klebstoffs oder Lots (4), verbunden sind.

4. Solarzellenmodul nach einem der vorhergehenden Ansprüche,
**dadurch gekennzeichnet, dass** die Trägerstruktur ein Trägerband oder eine Trägerplatte ist.

5. Solarzellenmodul nach einem der vorhergehenden Ansprüche,
**dadurch gekennzeichnet, dass** die Trägerstruktur aus einem Metall oder einer Metalllegierung mit einer Wärmeleitfähigkeit > 50 W/mK, insbesondere aus Kupfer, einer Kupfer-Eisen- oder einer Kupfer-Nickel-Legierung, besteht.

6. Solarzellenmodul nach einem der vorhergehenden Ansprüche,
**dadurch gekennzeichnet, dass** die Trägerstruktur eine Dicke im Bereich von 0,1 bis 5 mm, insbesondere 0,2 bis 0,5 mm aufweist.

7. Solarzellenmodul nach einem der vorhergehenden Ansprüche,
**dadurch gekennzeichnet, dass** die Trägerstruktur zumindest bereichsweise mit mindestens einer weiteren metallischen Beschichtung, insbesondere eine Diffusionsbarriere, bevorzugt aus Nickel, Palladium oder Silber, oder einer Oxidationsbarriere, bevorzugt aus Gold, zur Verbesserung der elektrischen Kontaktierbarkeit, versehen ist.

8. Solarzellenmodul nach einem der vorhergehenden Ansprüche,
**dadurch gekennzeichnet, dass** die Rückseitenplatte (12) eine Dicke von 50 bis 500 µm aufweist.

9. Solarzellenmodul nach einem der vorhergehenden Ansprüche,
**dadurch gekennzeichnet, dass** die Rückseitenplatte (12) aus einem Metall oder einer Metalllegierung mit einer Wärmeleitfähigkeit ≥ 50 W/mK, insbesondere aus einer Aluminiumlegierung, besteht.

10. Solarzellenmodul nach einem der vorhergehenden Ansprüche,
**dadurch gekennzeichnet, dass** als elektrische Isolierung von Trägerstruktur und Rückseitenplatte (12) eine Isolationsschicht (13), insbesondere aus Aluminiumoxid, zwischen Trägerstruktur und Rückseitenplatte (12) angeordnet ist.

11. Solarzellenmodul nach einem der vorhergehenden Ansprüche,
**dadurch gekennzeichnet, dass** die Rückseitenplatte (12) zusätzlich mit einer Substratplatte (15), insbesondere aus Stahl, Kunststoff, Glas und/oder Glasfaserverbundwerkstoffen, zur mechanischen Stabilisierung verbunden ist.

12. Solarzellenmodul nach einem der vorhergehenden Ansprüche,
**dadurch gekennzeichnet, dass** die elektrischen Kontaktierungen Bonddrähte (7,8) sind.

13. Solarzellenmodul nach einem der vorhergehenden Ansprüche,
**dadurch gekennzeichnet, dass** das Solarzellenmodul eine zusätzliche mechanische Fixierung für die Trägerstruktur, insbesondere eine Spritzguss-Verkapselung (9), ein Fixierband und/oder ein stoffschlüssig verbundenes Hilfselement (10), aufweist.

14. Solarzellenmodul nach einem der vorhergehenden Ansprüche,
**dadurch gekennzeichnet, dass** das Solarzellenmodul zusätzlich mindestens eine Schutzdiode (6) zur Ableitung von elektrischen Strömen in Sperrrichtung der Solarzelle (3) aufweist, wobei die Schutzdioden (6) bevorzugt auf den ersten Bereichen der Trägerstruktur (1) angeordnet sind.

15. Solarzellenmodul nach Anspruch 14,
**dadurch gekennzeichnet, dass** die Schutzdioden (6) jeweils vorderseitig mit einer benachbarten Solarzelle (3) elektrisch kontaktiert sind.

16. Solarzellenmodul nach einem der vorhergehenden Ansprüche,
**dadurch gekennzeichnet, dass** die Solarzellenmodule mit einer Korrosionschutzschicht versehen sind.

17. Solarzellenmodul nach einem der vorhergehenden Ansprüche,
**dadurch gekennzeichnet, dass** die Solarzellen monolithische Mehrfachsolarzellen, insbesondere Dreifach-Solarzellen, insbesondere aus Elementen der III. und V. Hauptgruppe des Periodensystems, sind.

18. Konzentrator-Solarzellenmodul enthaltend ein Solarzellenmodul nach einem der vorhergehenden Ansprüche und eine optische Vorrichtung zur Konzentrierung der Sonnenenergie, wobei die optische Vorrichtung bevorzugt eine einstufige oder zweistufige Konzentrator-Optik ist.

## Claims

1. A solar cell module containing at least two interconnected assemblies (SCA, 17) that comprise solar cells, and a module baseplate containing an electrically conductive carrier structure and a rear-side plate (12) that is electrically insulated with respect to the carrier structure, wherein the carrier structure has regions (SCA regions, 1) equipped separately from one another with solar cell assemblies and also connection regions (2), and the solar cell assemblies are connected by electrical contacting of the SCA regions (1) with the front side of an adjacent solar cell (3) and by electrical contacting of each of the SCA regions (1) with an adjacent connection region (2) as series connection, or of SCA regions (1) with one another and connection regions (2) with one another as parallel connection, and wherein a two-stage heat spread occurs with a first heat spread over the SCA region (1) and a second heat spread over the rear-side plate (12).

2. The solar cell module according to claim 1, **characterised in that** the carrier structure is of monolithic origin and the regions (1, 2) are separated by free stamping.

3. The solar cell module according to either one of the preceding claims, **characterised in that** the solar cells (3) are connected to the carrier structure in an integrally bonded manner, in particular by means of an adhesive or solder (4).

4. The solar cell module according to any one of the preceding claims, **characterised in that** the carrier structure is a carrier strip or a carrier plate.

5. The solar cell module according to any one of the preceding claims, **characterised in that** the carrier structure is made of a metal or a metal alloy with a thermal conductivity > 50 W/mK, in particular made of copper, a copper-iron alloy or a copper-nickel alloy.

6. The solar cell module according to any one of the preceding claims, **characterised in that** the carrier structure has a thickness in the range of from 0.1 to 5 mm, in particular 0.2 to 0.5 mm.

7. The solar cell module according to any one of the preceding claims, **characterised in that** the carrier structure is provided at least in regions with at least one further metallic coating, in particular a diffusion barrier, preferably made of nickel, palladium or silver, or an oxidation barrier, preferably made of gold, in order to improve the electrical contactability.

8. The solar cell module according to any one of the preceding claims, **characterised in that** the rear-side plate (12) has a thickness of 50 to 500 pm.

9. The solar cell module according to any one of the preceding claims, **characterised in that** the rear-side plate (12) is made of a metal or a metal alloy with a thermal conductivity ≥ 50 W/mK, in particular is made of an aluminium alloy.

10. The solar cell module according to any one of the preceding claims, **characterised in that** an insulation layer (13), in particular made of aluminium oxide, is arranged between the carrier structure and rear-side plate (12) as electrical insulation of the carrier structure and rear-side plate (12).

11. The solar cell module according to any one of the preceding claims, **characterised in that** the rear-side plate (12) is additionally connected to a substrate plate (15), in particular made of steel, plastic, glass and/or glass fibre composite materials, for mechanical stabilisation.

12. The solar cell module according to any one of the preceding claims, **characterised in that** the electrical contact-making means are bond wires (7, 8) .

13. The solar cell module according to any one of the preceding claims, **characterised in that** the solar cell module has an additional mechanical fixing for the carrier structure, in particular an injection-moulded encapsulation (9), a fixing strip and/or an auxiliary element (10) connected in an integrally bonded manner.

14. The solar cell module according to any one of the preceding claims, **characterised in that** the solar cell module additionally has at least one protective diode (6) for dissipating electrical currents in the reverse direction of the solar cell (3), wherein the protective diodes (6) are preferably arranged on the first regions of the carrier structure (1).

15. The solar cell module according to claim 14, **characterised in that** the protective diodes (6) are each electrically contacted on the front side to an adjacent solar cell (3).

16. The solar cell module according to any one of the preceding claims, **characterised in that** the solar cell modules are provided with an anti-corrosion layer.

17. The solar cell module according to any one of the preceding claims, **characterised in that** the solar cells are monolithic multi-junction solar cells, in particular triple-junction solar cells, in particular formed of elements from main groups III and V of the Periodic Table.

18. A concentrator solar cell module containing a solar cell module according to any one of the preceding claims and an optical device for concentrating the solar energy, wherein the optical device is preferably a one-stage or two-stage concentrator optics.

## Revendications

1. Module de cellules solaires, contenant au moins deux ensembles (SCA, 17) présentant des cellules solaires (3) reliées entre elles ainsi qu'une plaque de fond de module contenant une structure de support électriquement conductrice et une plaque arrière (12) électriquement isolée vis-à-vis de la structure de support, la structure de support présentant des zones (zones SCA, 1) séparées les unes des autres et équipées d'ensembles de cellules solaires ainsi que des zones de raccordement (2), et un raccordement des ensembles de cellules solaires s'effectuant par une mise en contact électrique des zones SCA (1) avec le côté avant d'une cellule solaire (3) voisine ainsi que par une mise en contact électrique des zones SCA (1) avec respectivement une zone de raccordement (2) voisine en tant que montage en série ou de zones SCA (1) entre elles et de zones de raccordement (2) entre elles en tant que montage en parallèle, et une diffusion de chaleur à deux étages avec une première diffusion de chaleur s'effectuant par le biais de la zone SCA (1) et avec une deuxième diffusion de chaleur s'effectuant par le biais de la plaque arrière (12).

2. Module de cellules solaires selon la revendication 1, **caractérisé en ce que** la structure de support est d'origine monolithique, et la séparation des zones (1, 2) est effectuée par estampage libre.

3. Module de cellules solaires selon l'une des revendications précédentes,
**caractérisé en ce que** les cellules solaires (3) sont raccordées à la structure de support par liaison de matière, en particulier au moyen d'une colle ou d'un brasage (4).

4. Module de cellules solaires selon l'une des revendications précédentes,
**caractérisé en ce que** la structure de support est une bande de support ou une plaque de support.

5. Module de cellules solaires selon l'une des revendications précédentes,
**caractérisé en ce que** la structure de support se compose d'un métal ou d'un alliage métallique avec une conductivité thermique > 50 W/mK, en particulier en cuivre, en alliage cuivre-fer ou en alliage cuivre-nickel.

6. Module de cellules solaires selon l'une des revendications précédentes,
**caractérisé en ce que** la structure de support présente une épaisseur dans la plage de 0,1 à 5 mm, en particulier de 0,2 à 0,5 mm.

7. Module de cellules solaires selon l'une des revendications précédentes,
**caractérisé en ce que** la structure de support est, au moins par tronçons, munie d'un autre revêtement métallique, en particulier une barrière de diffusion, de préférence en nickel, palladium ou argent, ou une barrière d'oxydation, de préférence en or, pour l'amélioration de l'aptitude à l'établissement d'un contact électrique.

8. Module de cellules solaires selon l'une des revendications précédentes, **caractérisé en ce que** la plaque arrière (12) présente une épaisseur de 50 à 500 µm.

9. Module de cellules solaires selon l'une des revendications précédentes,
**caractérisé en ce que** la plaque arrière (12) se compose d'un métal ou d'un alliage métallique avec une conductivité thermique ≥ 50 W/mK, en particulier d'un alliage d'aluminium.

10. Module de cellules solaires selon l'une des revendications précédentes,
**caractérisé en ce que**, en tant qu'isolation électrique de la structure de support et de la plaque arrière (12), une couche d'isolation (13), en particulier en oxyde d'aluminium, est disposée entre la structure de support et la plaque arrière (12).

11. Module de cellules solaires selon l'une des revendications précédentes,
**caractérisé en ce que** la plaque arrière (12) est en plus raccordée à une plaque de substrat (15), en particulier en acier, matière plastique, verre et/ou matériaux composites avec fibre de verre, pour la stabilisation mécanique.

12. Module de cellules solaires selon l'une des revendications précédentes, **caractérisé en ce que** les contacts électriques sont des fils de liaison (7, 8).

13. Module de cellules solaires selon l'une des revendications précédentes,
**caractérisé en ce que** le module de cellules solaires présente une fixation mécanique supplémentaire pour la structure de support, en particulier une encapsulation moulée par injection (9), une bande de fixation et/ou un élément auxiliaire (10) raccordé par liaison de matière.

14. Module de cellules solaires selon l'une des revendications précédentes,
**caractérisé en ce que** le module de cellules solaires présente en plus au moins une diode de protection (6) destinée à dévier des courants électriques dans le sens de blocage de la cellule solaire (3), les diodes de protection (6) étant disposées de préférence sur les premières zones de la structure de support (1).

15. Module de cellules solaires selon la revendication 14,
**caractérisé en ce que** les diodes de protection (6) sont respectivement mises en contact électrique sur le côté avant avec une cellule solaire (3) voisine.

16. Module de cellules solaires selon l'une des revendications précédentes,
**caractérisé en ce que** les modules de cellules solaires sont munis d'une couche anticorrosion.

17. Module de cellules solaires selon l'une des revendications précédentes,
**caractérisé en ce que** les cellules solaires sont des cellules solaires multiples monolithiques, en particulier des cellules solaires triples, en particulier en éléments du IIIème et du Vème groupe principal du système périodique.

18. Modules de cellules solaires à concentration, contenant un module de cellules solaires selon l'une des revendications précédentes et un dispositif optique destiné à la concentration de l'énergie solaire, le dispositif optique étant de préférence une optique de concentrateur à un étage ou à deux étages.
